## Europäisches Patentamt
## European Patent Office
## Office européen des brevets

(11) Veröffentlichungsnummer: **0 151 769 B1**

(12) **EUROPÄISCHE PATENTSCHRIFT**

(45) Veröffentlichungstag der Patentschrift: **04.09.91**

(51) Int. Cl.⁵: **H03M 1/36**

(21) Anmeldenummer: **84115747.2**

(22) Anmeldetag: **18.12.84**

(54) **Integrierbarer Analog/Digitalwandler.**

(30) Priorität: **15.02.84 DE 3405438**

(43) Veröffentlichungstag der Anmeldung:
**21.08.85 Patentblatt 85/34**

(45) Bekanntmachung des Hinweises auf die
Patenterteilung:
**04.09.91 Patentblatt 91/36**

(84) Benannte Vertragsstaaten:
**AT DE FR GB IT NL**

(56) Entgegenhaltungen:
**US-A- 4 008 468**
**US-A- 4 217 574**

**PATENT ABSTRACTS OF JAPAN, Band 5, Nr. 137 (E-72)[809], 29. August 1981; & JP-A-56 72 527**

**PATENT ABSTRACTS OF JAPAN, Band 7, Nr. 52 (E-162)[1197], 2. März 1983; & JP-A-57 203 326**

**IEEE International solid state circuits conference, 1976, Seiten 150-151**

(73) Patentinhaber: **Siemens Aktiengesellschaft
Wittelsbacherplatz 2
W-8000 München 2(DE)**

(72) Erfinder: **Zojer, Bernhard, Dipl.-Ing.
Bahnofplatz 9
A-9500 Villach(AT)**
Erfinder: **Petschacher, Reinhard, Dipl.-Ing.
Aufeldgasse 13
A-9500 Villach(AT)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services

EP 0 151 769 B1

**Beschreibung**

Die vorliegende Erfindung hat einen integrierbaren Analog/Digitalwandler zum Gegenstand, bei dem das zu verarbeitende Analogsignal gleichzeitig an den einen Eingang von n einander gleichen Komparatoren gelegt ist, während der andere Eingang jedes dieser Komparatoren an je einen Teilerpunkt eines aus n hintereinander geschalteten Widerständen bestehenden und an seinen Enden durch eine Referenzgleichspannung beaufschlagten Spannungsteilers liegt und die Ausgänge dieser Komparatoren eine gemeinsame Logikschaltung steuern, die das dem Analogsignal entsprechende Digitalsignal liefert.

Solche nach dem Parallelverfahren arbeitende Analog/Digitalwandler sind z.B. in dem Buch von Tietze und Schenk "Halbleiterschaltungstechnik" (1980), S. 653 - 657, in der US-A 4,099,173 bzw. in "IEEE Journal of Solid-State Circuits" Vol. SC 17, No. 6 (December 1982), S. 1133 -1138 beschrieben.

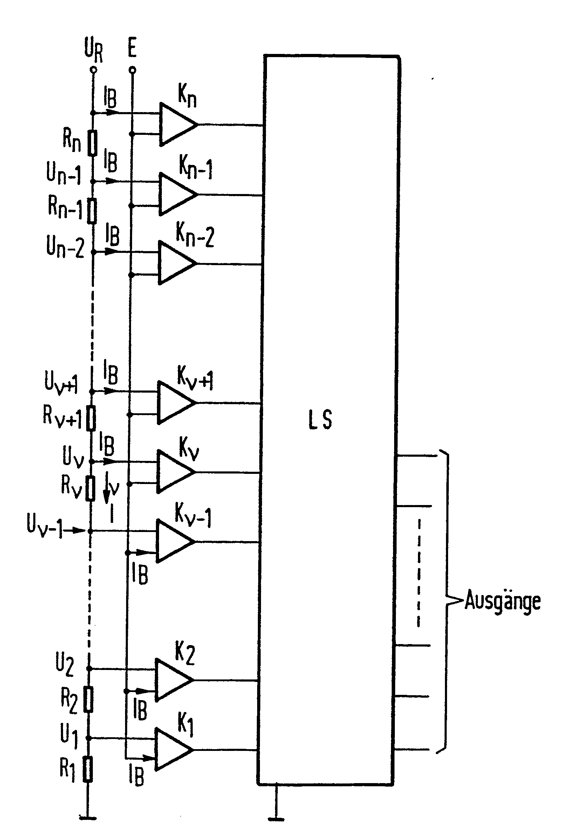

Ein vereinfachtes Blockschaltbild für einen solchen Analog/Digitalwandler ist in der Figur dargestellt, zu der folgendes festzustellen ist. Die n Komparatoren $K_1$, $K_2$,.. ..$K_n$ des Wandlers sind einander gleich und in üblicher Weise mit zwei Eingängen versehen, wovon der erste Eingang durch das zu verarbeitende Analogsignal E und der andere durch das Potential von dem dem betreffenden Komparator $K_\nu$ zugeordneten $\nu$-ten Teilerpunkt des von den n Widerständen $R_1$, $R_2$,...$R_n$ gebildeten Spannungsteilers ST beaufschlagt ist. Der dem Fußpunktspotential am nächsten liegende Teilerpunkt zwischen den Widerständen $R_1$ und $R_2$ des Spannungsteilers ST ist mit dem Referenzeingang des dem niedrigsten Ausgangscode des Wandlers LSB (also dem Digitalwert $2^0$) zugeordneten Komparator $K_1$ verbunden.

Allgemein ist der mit dem - in Richtung des wachsenden Abstands vom Fußpunktspotential gezählten - $\nu$-ten Teilerpunkt des Spannungsteilers ST verbundene Komparator $K_\nu$ dem $\nu$-ten Ausgangscode des Wandlers zugeordnet. Das andere Ende des aus n hintereinandergeschalteten Widerständen $R_1$, $R_2$,....$R_n$ bestehenden Spannungsteilers ST ist an ein externes Referenzpotential $U_R$ gelegt.

Die Ausgänge der Komparatoren $K_1$, $K_2$,...$K_n$ steuern je einen Eingang (oder zwei Eingänge) einer in üblicher Weise ausgestalteten Logikschaltung LS, die insbesondere als Encoder wirksam ist und deren detaillierter Aufbau für die vorliegende Erfindung ohne Belang ist.

Wird nun zur Erzeugung der n = $2^k$ für einen k-bit-Parallel-A/D-Umsetzer benötigten Referenzspannungen ein Spannungsteiler aus n einander ideal gleichen Referenzwiderständen $R_\nu$ (= $R_0$) verwendet, so treten aufgrund der durch diese Widerstände fließenden Eingangsströme $I_B$ der Komparatoren Abweichungen von den Sollwerten der Referenzspannungen an den durch den Spannungsteiler beaufschlagten Referenzeingängen der einzelnen Komparatoren $K_\nu$ auf, die ihrerseits Nichtlinearitäten bedingen. Die Größe dieser Abweichungen ist von der Höhe der Analogspannung E abhängig und liegt für den $\nu$-ten Komparator $K_\nu$ zwischen dem Wert Null und einem Maximalwert von

$$U_\nu = (n - \nu)(n - \nu + 1) \cdot R_0 \cdot I_B/2n.$$

Um nun zu erreichen, daß der Linearitätsfehler nicht größer als das halbe LSB (= niederwertigste Bit) werden kann, muß der Wert $R_0$ für die einzelnen Widerstände R des Spannungsteilers die Bedingung

$$R_0 < 27 \, U_R/4I_B \cdot n^3$$

erfüllen. Der durch den Spannungsteiler ST fließende Querstrom $I_s$ genügt dann der Bedingung

$$I_s > 4I_B \cdot n^2/27.$$

Man kann nun den Strom $I_B$ durch Emitterfolger am Komparatoreingang verkleinern. Diese Möglichkeit ist jedoch bei größer werdender Bitzahl in den A/D-Wandlern nicht mehr ausreichend, um vernünftige Grenzwerte für die den Teiler bildenden Widerstände $R_0$ und den Querstrom $I_s$ zu ermöglichen.

Man muß dann auf sehr aufwendige Konzepte zurückgreifen, wie sie z.B. durch die Konstanthaltung von Teilspannungen unter Verwendung von laser-getrimmten Widerständen im Spannungsteiler ST und Operationsverstärkern gegeben sind. Diese Möglichkeiten sind in "1976 IEEE International Solid-State Circuits Conference, S. 150, 151" sowie in "IEEE Journal of Solid-State Circuits, Vol. SC-17, No.6 (December 1982), S. 1133- 1138" beschrieben.

Da es wünschenswert ist, eine weniger aufwendige Lösung des genannten Problems der Vermeidung der genannten Nichtlinearitäten zur Verfügung zu haben, hat sich die vorliegende Erfindung mit dieser Aufgabe befaßt und schlägt nun die im folgenden zu definierende und zu beschreibende Lösung vor.

Gemäß der vorliegenden Erfindung ist bei einem der eingangs gegebenen Definition entsprechenden

2

Analog/Digitalwandler vorgesehen, daß der den dem $\nu$-ten Ausgangscode zugeordneten Komparator $K_\nu$ - ($\nu$ = 1, 2,....n) an seinem Referenzeingang beaufschlagende $\nu$-te Teilerpunkt des Spannungsteilers ST von dem dem nächst niedrigeren Ausgangscode zugeordneten Teilerpunkt des Spannungsteilers durch einen Widerstand getrennt ist. dessen Wert $R_\nu$ der Bedingung

$$R_y^2 + \left[\sum_{k=1}^{n-\nu}\left\{(k+1)\cdot R_{\nu+k}\right\} - \sum_{k=1}^{\nu} R_k - (U_R/I_B)\right]\cdot R_\nu +$$

$$+ \left[((U_R - U_{\nu-1})/I_B) - \sum_{k=1}^{n-\nu}(k+1)\cdot R_{\nu+k}\right]\cdot \sum_{k=1}^{\nu} R_k -$$

$$- (U_{\nu-1}/I_B)\cdot \sum_{k=1}^{n-\nu} R_{\nu+k}) = 0$$

genügt. Dabei ist $U_R$ die am Spannungsteiler ST liegende Referenzspannung, $I_B$ der über den Referenzeingang des einzelnen Komparators $K_\nu$ fließende Strom.

Zum Verständnis der Erfindung wird zunächst die sachliche Begründung der soeben angegebenen Dimensionierung für die Widerstände $R_\nu$ des Spannungsteilers ST gebracht. Anschließend wird ein Beispiel für deren Anwendung zur Bestimmung des Widerstandswerts für die einzelnen Widerstände gebracht.

Der für die Erfindung wesentliche Gesichtspunkt ist dabei die Tatsache, daß es zur Realisierung eines ideal linearen Analog/Digitalwandlers genügt, wenn für eine beliebige Spannung $U_{An}$ am Analogeingang des Wandlers (gebildet durch die Signaleingangsklemme E und die Klemme für das Fußpunktspotential) zum Abtastzeitpunkt $t_o$ diejenige Referenzspannung den Sollwert U annimmt, für die die Bedingung

$$U_\nu > U_{An}(t_o) \geqq U_{\nu-1}$$

gilt. Die Werte der übrigen Referenzspannungen können hingegen zu diesem Zeitpunkt $t_o$ von ihren Sollwerten abweichen, weil sie dann keinen Einfluß auf den Signalausgang des Wandlers haben. Die mathematische Formulierung dieses Sachverhalts liefert bei der Vorgabe der Sollwerte für $U_\nu$ ein System von (n-1) nichtlinearen Gleichungen in den n Widerständen $R_\nu$ des Spannungsteilers ST. Einer dieser Widerstände kann dabei als Ausgangswert freigewählt werden.

Dieses Gleichungssystem ist rekursiv einfach auflösbar und liefert explizit die notwendigen Korrekturen der Widerstandswerte. Sind dann die Widerstandswerte des Spannungsteilers ST in diesem Sinne eingestellt, so kann eine Abweichung von der Linearität nur noch durch Schwankungen des in dem genannten Gleichungssystem als konstant angenommenen Komparatoreingangsstroms $I_B$ verursacht werden.

Nimmt man nun bei der in der Zeichnung dargestellten Beauf-Beaufschlagung der n Komparatoren $K_1$, $K_2$,..$K_n$ durch den Spannungsteiler ST an, daß die referenzseitigen Eingangsströme $I_B$ der Komparatoren $K_1$ bis unmittelbar vor dem jeweils betrachteten Komparator $K_\nu$ gleich Null sind, wenn die am Analogeingang E des Wandlers anhängige Signalspannung $U_A$ größer als die an dem Referenzeingang des ($\nu$-1)-ten Komparators, also am Komparator $K_{\nu-1}$ anhängige Signalspannung und kleiner als der Sollwert $U_\nu$ der Referenzspannung am Komparator $K_\nu$ ist, dann gilt für den dem Komparator $K_\nu$ zugeordneten Teilerpunkt des Spannungsteilers ST

$$(I) \qquad U_\nu = \sum_{k=1}^{\nu} R_k \cdot I_\nu$$

und

$$(II) \qquad U_R - U_\nu = \sum_{k=1}^{n-\nu}(I_\nu + k\cdot I_B)\, R_{\nu+k}.$$

Aus diesen beiden Gleichungen folgt unmittelbar:

$$(III) \quad (U_R - U_\nu) \sum_{k=1}^{\nu} R_k = U_\nu \sum_{k=1}^{n-\nu} R_{\nu+k} + I_B \sum_{i=1}^{\nu} R_i \cdot \sum_{k=1}^{n-\nu} k \cdot R_{\nu+k},$$

mit $1 \leq \nu \leq (n-1)$.

Gibt man nun den vorgesehenen Sollwert für die vom Spannungsteiler ST zu liefernden Referenzspannungen $U_\nu$ vor, so kann man das Gleichungssystem (III) ohne weiteres auflösen. Zum Beispiel kann man inanbetracht der wünschwenswerten Gleichbemessung der Referenzspannung für $U_\nu$ die Beziehung

$$U_\nu = U_R \cdot \nu/n$$

verwenden. Es können aber auch Spannungsabfälle an der Analogsignalleitung mitberücksichtigt werden.

Das durch (III) gegebene System von (n-1) Gleichungen für die n Widerstände $R_\nu$ läßt sich folgenderweise leicht auflösen. Setzt man nämlich in die (III) die Identität

$$\sum_{k=1}^{\nu} R_k = \sum_{k=1}^{\nu+1} R_k - R_{\nu+1}$$

ein, so erhält man nach einigen Umformungen des Gleichungssystems die Beziehung

$$R_\nu^2 + \left\{ \sum_{k=1}^{n-\nu} (k+1) \cdot R_{\nu+k} - \sum_{k=1}^{\nu} R_k - (U_R/I_B) \right\} \cdot R_\nu +$$

$$+ \left\{ ((U_R - U_{\nu-1})/I_B) - \sum_{k=1}^{n-\nu} (k+1) \cdot R_{\nu+k} \right\} \cdot \sum_{k=1}^{\nu} R_k -$$

$$- (U_{\nu-1}/I_B) \cdot \sum_{k=1}^{n-\nu} R_{\nu+k} = 0.$$

Wenn man den Mittelwert $R_0$ der Widerstände R vorgibt, kann man das durch diese Beziehung gegebene System leicht rekursiv auflösen, wie nun gezeigt wird:

a) $\nu = n$:

Hier hat man

$$\sum_{k=1}^{n} R_k = n \cdot R_0$$

und

$$R_n^2 + \left\{ - n \cdot R_0 - (U_R/I_B) \right\} \cdot R_n + (U_R - U_{n-1}) \cdot n \cdot R_0/I_B = 0.$$

Hieraus läßt sich $R_n$ unmittelbar bestimmen.

b) $\nu = (n-1)$:

Hier hat man

$$\sum_{k=1}^{n-1} R_k = \sum_{k=1}^{n} R_k - R_n = n \cdot R_0 - R_n$$

und

$$R_{n-1}^2 + \left\{ 2R_n - (n \cdot R_0 - R_n) - (U_R/I_B) \right\} \cdot R_{n-1} +$$
$$+ ((U_R - U_{n-2}/I_B) - 2R_n) \cdot (nR_0 - R_n) - U_{n-2} \cdot R_n/I_B = 0.$$

Hieraus läßt sich der Wert $R_{n-1}$ unmittelbar bestimmen.

c) Sukzessive wird dann hieraus $R_{n-2}$, dann $R_{n-3}$ usw., also $R_\nu$ bis zum Wert $\nu = 2$ in der aus a) und b) ersichtlichen Weise berechnet.

Der Wert für $R_1$ ist dann durch die Beziehung

$$R_1 = \sum_{k=1}^{2} R_k - R_2$$

bestimmt.

Man kann also das die Bemessungsgrundlage für die Erfindung bildende Gleichungssystem ohne weiteres auflösen, um die für den Spannungsteiler ST erforderlichen Widerstände sukzessive zu bestimmen.

**Patentansprüche**

1. Analog/Digitalwandler, bei dem das zu verarbeitende Analogsignal gleichzeitig an jeweils den einen Eingang von n einander gleichen Komparatoren gelegt ist, während der andere Eingang jedes dieser Komparatoren an je einen Teilerpunkt eines aus n hintereinandergeschalteten Widerständen bestehenden und an seinen Enden durch eine Referenzgleichspannung beaufschlagten Spannungsteilers liegt, bei dem die Ausgänge dieser Komparatoren eine gemeinsame Logikschaltung steuern, die das dem zu verarbeitenden Analogsignal entsprechende Digitalsignal liefert, **dadurch gekennzeichnet,** daß der den dem $\nu$-ten Ausgangscode jeweils zugeordnete Komparator $K_\nu$ mit $\nu = 1, 2, \ldots n$ jeweils beaufschlagende $\nu$-te Teilerpunkt des Spannungsteilers (ST) vor dem dem nächst niedrigeren Ausgangscode zugeordneten Teilerpunkt des Spannungsteilers (ST) durch einen Widerstand $(R_\nu)$ getrennt ist, dessen Wert der Bedingung

$$R_\nu^2 + \left[ \sum_{k=1}^{n-\nu} \left\{ (k+1) \cdot R_{\nu+k} \right\} - \sum_{k=1}^{\nu} R_k - (U_R/I_B) \right] \cdot R_\nu +$$
$$+ \left[ ((U_R - U_{\nu-1})/I_B) - \sum_{k=1}^{n-\nu} (k+1) R_{\nu+k} \right] \cdot \sum_{k=1}^{\nu} R_k - (U_{\nu-1}/I_B) \cdot$$
$$\cdot \sum_{k=1}^{n-\nu} R_{\nu+k} = 0,$$

genügt, wobei $U_R$ die für den Spannungsteiler (ST) zu verwendende Referenzspannung ist, und wobei über den Referenzeingang der einzelnen Komparatoren $K_\nu$ nur dann ein Strom $I_B$ fließt, wenn die Referenzspannung am Komparator $K_\nu$ größer ist als die Spannung des Analogsignals.

5

**Claims**

1. Analog-to-digital converter, in which the analog signal to be processed is connected simultaneously to respectively one input of n mutually identical comparators, while the other input of each of these comparators is respectively connected to one divider point of a voltage divider, which consists of n series-connected resistors and to whose ends a d.c. reference voltage is applied, in which the outputs of these comparators control a common logic circuit, which furnishes the digital signal corresponding to the analog signal to be processed, characterised in that the $_{\nu}$th divider point of the voltage divider (ST), which divider point is applied respectively to the comparator $K_{\nu}$, where $_{\nu}$ = 1, 2, ...n, respectively assigned to the $_{\nu}$th output code, is separated from the divider point, assigned to the next lowest output code, of the voltage divider (ST) by a resistor ($R_{\nu}$) whose value satisfies the condition

$$R_{\nu}^2 + \left[ \sum_{k=1}^{n-\nu} \left\{ (k+1) \cdot R_{\nu+k} \right\} - \sum_{k=1}^{\nu} R_k - (U_R/I_B) \right] \cdot R_{\nu} +$$

$$+ \left[ ((U_R - U_{\nu-1})/I_B) - \sum_{k=1}^{n-\nu} (k+1) R_{\nu+k} \right] \cdot \sum_{k=1}^{\nu} R_k - (U_{\nu-1}/I_B) \cdot$$

$$\cdot \sum_{k=1}^{n-\nu} R_{\nu+k} = 0,$$

$U_R$ being the reference voltage to be used for the voltage divider (ST), and a current $I_B$ flowing via the reference input of the individual comparators $K_{\nu}$ only if the reference voltage at the comparator $K_{\nu}$ is greater than the voltage of the analog signal.

**Revendications**

1. Convertisseur analogique/numérique dans lequel le signal analogique devant être traité est appliqué simultanément respectivement à une entrée de n comparateurs identiques, tandis que l'autre entrée de chacun de ces comparateurs est raccordée respectivement à un point d'un diviseur de tension constitué par n résistances branchées en série et chargé, à ses extrémités, par une tension continue de référence, et dans lequel les sorties de ces comparateurs commandent un circuit logique commun qui délivre le signal numérique correspondant au signal analogique devant être traité, caractérisé par le fait que le $\nu$-ème point du diviseur de tension (ST), qui charge respectivement le comparateur $K_{\nu}$, associé respectivement au $\nu$-ème code de sortie, avec $\nu$ = 1, 2, ... n, est séparé du point, associé au code de sortie de rang immédiatement inférieur, du diviseur de tension (ST) par une résistance $R_{\nu}$, dont la valeur satisfait à la relation

$$R_{\nu}^2 + \left[ \sum_{k=1}^{n-\nu} \left\{ (k+1) \cdot R_{\nu+K} \right\} - \sum_{K=1}^{\nu} R_k - (U_R/I_B) \right] \cdot R_{\nu} +$$

$$+ \left[ ((U_R - U_{\nu-1})/I_B) - \sum_{k=1}^{n-\nu} (k+1) R_{\nu+k} \right] \cdot \sum_{k=1}^{\nu} R_k - (U_{\nu-1}/I_B) \cdot$$

$$\cdot \sum_{k=1}^{n-\nu} R_{\nu+k} = 0,$$

$U_R$ désignant la tension de référence qui doit être utilisée pour le diviseur de tension (ST), tandis qu'un courant $I_B$ circule à l'entrée de référence des différents comparateurs $K_{\nu}$, uniquement lorsque la tension de référence aux bornes du comparateur $K_{\nu}$ est supérieure à la tension du signal analogique.